(19) **Europäisches Patentamt / European Patent Office / Office européen des brevets**

(11) **EP 2 415 066 B1**

(12) **EUROPEAN PATENT SPECIFICATION**

(45) Date of publication and mention
of the grant of the patent:
**21.08.2013 Bulletin 2013/34**

(51) Int Cl.:
*H01J 37/305* (2006.01)   *G01N 1/28* (2006.01)

(21) Application number: **10725231.4**

(86) International application number:
**PCT/GB2010/000599**

(22) Date of filing: **29.03.2010**

(87) International publication number:
**WO 2010/112827 (07.10.2010 Gazette 2010/40)**

(54) **METHOD AND APPARATUS FOR PRODUCING THREE DIMENSIONAL NANO AND MICRO SCALE STRUCTURES**

VERFAHREN UND VORRICHTUNG ZUR HERSTELLUNG VON DREIDIMENSIONALEN STRUKTUREN AUF NANO- UND MIKROMASSSTAB

PROCÉDÉ ET APPAREIL DE FABRICATION DE NANOSTRUCTURES ET DE MICROSTRUCTURES EN TROIS DIMENSIONS

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **31.03.2009 GB 0905571**

(43) Date of publication of application:
**08.02.2012 Bulletin 2012/06**

(73) Proprietors:
• **The Secretary of State for Business Innovation and
Skills for Her Majesty's Britannic Government**
London SW1 0ET (GB)
• **University of Surrey**
Surrey GU1 7XH (GB)

(72) Inventor: **COX, David**
**Surrey GU15 4JW (GB)**

(74) Representative: **Jehan, Robert**
**Williams Powell
Staple Court
11 Staple Inn Buildings
London, WC1V 7QH (GB)**

(56) References cited:
EP-A1- 1 598 312    WO-A1-2006/050613
JP-A- 2007 069 329    JP-A- 2007 184 175
US-A1- 2004 022 161    US-A1- 2004 154 744
US-A1- 2004 256 577    US-A1- 2006 286 772

US-A1- 2008 265 158

• VASILE M J ET AL: "Focused ion beam milling: Depth control for three-dimensional microfabrication" JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 15, no. 6, 1 November 1997 (1997-11-01), pages 2350-2354, XP007914118 ISSN: 0734-211X

• VASILE MICHAEL J ET AL: "Depth control of focused ion-beam milling from a numerical model of the sputter process" JOURNAL OF VACUUM SCIENCE & TECHNOLOGY B: MICROELECTRONICSPROCESSING AND PHENOMENA, AMERICAN VACUUM SOCIETY, NEW YORK, NY, US LNKD- DOI:10.1116/1.590959, vol. 17, no. 6, 1 November 1999 (1999-11-01), pages 3085-3090, XP012007882 ISSN: 0734-211X

• VASILE MICHAEL J ET AL: "Focused ion beam technology applied to microstructure fabrication" JOURNAL OF VACUUM SCIENCE & TECHNOLOGY B: MICROELECTRONICSPROCESSING AND PHENOMENA, AMERICAN VACUUM SOCIETY, NEW YORK, NY, US LNKD- DOI:10.1116/1.590198, vol. 16, no. 4, 1 July 1998 (1998-07-01), pages 2499-2505, XP012007044 ISSN: 0734-211X

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a method and apparatus for producing three-dimensional nano and micro structures and to such structures.

There is a growing industry for miniaturised devices, many on the micrometre or nanometre scale. The manufacture of such devices presents a challenge to the industry, particularly for devices which can be manufactured with high reliability and precision.

The applicant's earlier British patent application no. 2,438,241 discloses methods of machining components, such as thermocouple or SQUIDs using ion beam milling. Ion beam milling is performed on a material to expose a sliver. A sharp probe is then attached to the sliver, for example by deposition of a tungsten weld. Further ion beam milling is then performed to separate the sliver from the material. The sliver is then ion beam milled to produce the device. In some embodiments, the thermocouple is mounted to a substrate such as a silicon wafer having integrated signal conditioning circuitry. The methods allows small components to be accurately manufactured without being constrained by typical lithographic constraints.

The applicant's earlier British patent application is particularly suitable for making two dimensional cuts in a substrate and some three dimensional structures.

A method of milling a three-dimensional form for the production of a three-dimensional structure is also known from:

-   VASILE M J ET AL: "Focused ion beam milling: Depth control for three-dimensional microfabrication", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 15, no. 6, 1 November 1997 (1997-11-01), pages 2350-2354;
-   VASILE MICHAEL J ET AL: "Depth control of focused ion-beam milling from a numerical model of the sputter process", JOURNAL OF VACUUM SCIENCE & TECHNOLOGY B: MICROELECTRONICSPROCESSING AND PHENOMENA, AMERICAN VACUUM SOCIETY, NEW YORK, NY, vol. 17, no. 6, 1 November 1999 (1999-11-01), pages 3085-3090;
-   VASILE MICHAEL J ET AL: "Focused ion beam technology applied to microstructure fabrication", JOURNAL OF VACUUM SCIENCE & TECHNOLOGY B: MICROELECTRONICSPROCESSING AND PHENOMENA, AMERICAN VACUUM SOCIETY, NEW YORK, NY, vol. 16, no. 4, 1 July 1998 (1998-07-01), pages 2499-2505.

The present invention seeks to provide an improved method and apparatus able to produce reliably and with high precision nano and micrometre structures and to such structures.

According to an aspect of the present invention there is provided a method of milling a three-dimensional form as described in claim 1.

Preferably, the milling step comprises a plurality of milling passes.

Advantageously, in milling over a plurality of passes, the method includes the step of milling at least one following pass in the plurality of passes over a region milled in a previous pass.

In the preferred embodiment, said following milling pass mills over a part of a previous milled pass.

Advantageously, at least some sequential milling passes are milled concentrically. Additionally or alternatively, at least some sequential milling passes are milled non-concentrically.

The method includes the step of measuring actual milled depth within a milled structure. The milled depth may be measured by means of an atomic force microscope. Preferably, milling depth is measured during the step of milling. It may be measured prior to milling a subsequent area within the milling step.

In the preferred embodiment, the method mills a three-dimensional article. In another embodiment, a replica of an article is milled, the replica being used in a subsequent manufacturing step to manufacture an article with a three-dimensional structure.

In the preferred embodiments the method mills three-dimensional structures having dimensions of the order of nanometres and/or micrometres. For instance, the method may mill a concave structure, for use for instance as a lens or mirror, having a diameter of the order of micrometres or nanometres and a depth of the order of micrometres or nanometres. The method may similarly mill convex articles.

The method preferably mills articles with substantially smooth surfaces.

According to another aspect of the present invention, there is provided a system for milling a three-dimensional pattern in a device as described in claim 11.

Preferably, the control unit is operable to control the ion column to mill the device in a plurality of milling passes.

Advantageously, the control unit is operable to control the intensity of the ion beam generated by the ion column and/or the dwell time of the ion beam.

The system preferably, includes a database of milling depth, beam intensity and beam dwell time for one or more materials. The database may be in the form of a look-up table.

Embodiments of the present invention are described below, with reference to the accompanying drawings, in which:

> Figure 1 is a schematic diagram of beam overlap showing pitch and spot size;
> Figure 2 is a schematic diagram of typical focused ion beam instrument with computer control for stage and scan-coils;
> Figure 3 is a schematic illustration of an AFM incorporated onto the sample stage to provide feedback about milled volume;
> Figure 4 is a plot of milled depths at 100pA for a range of beam conditions;
> Figure 5 is a plot of normalised milling rates at 100pA for a range of beam conditions;
> Figure 6 is a model output for parabolic dish of $10\mu m$ diameter and $10\mu m$ focal length showing 28 circles defining the parabolic dish;
> Figure 7 is a schematic diagram showing a first circle (first pass) which is milled from the outside edge in a circular motion of the beam in the production of a three-dimensional structure;
> Figure 8 shows the second milling pass in the embodiment method of Figure 7;
> Figure 9 shows a detail of the effects of the second and subsequent milling passes on the part-milled structure of Figure 8;
> Figure 10 is an enlarged view of the milling process of Figures 7, 8 and 9;
> Figure 11 shows an SEM micrograph of four parabolic dishes of differing focal length milled into silicon;
> Figure 12 shows a MATLAB map for use in generating milling data;
> Figure 13 is a two dimensional line plot of the "Gibbs effect" plotted in MATLAB;
> Figures 14a and 14b show three dimensional plots of the Gibbs effect for the first nine harmonics in the series, and its conversion to the colour map winter;
> Figure 15 shows a converted two dimensional plot using colour map winter, the intensity of G (green) and B (blue) in the image denoting height;
> Figure 16 shows an SEM micrograph of milled bitmap pattern, shown from three different views, the sample being shown tilted with respect to the beam to show the topography;
> Figure 17 shows in schematic form a plan view of an example of a simple mask for producing roughed-out parabolic dishes;
> Figure 18 is a cross-sectional view of a patterned etch stop sitting on a wafer substrate, alignment marks not being shown for the sake of clarity;
> Figure 19 is a cross-sectional view of an example of etched wafer substrate; and
> Figure 20 is a cross-sectional view in plan elevation of an individual etched hole with the dashed line showing to desired final shape to produce a parabolic dish.

The inventor has discovered that ion milling can be a very powerful tool for machining and modification of nano and microstructures. For example, this process in one of its simplest implementations can be used to produce site-specific TEM foils. In more complicated examples it can be used for the fabrication of MEMS devices. However, the nature of the process dictates that when ion milling, the structures produced are milled perpendicular to the beam, resulting in a milled final surface parallel to the original surface, that is holes with flat bottoms. When scanning the ion beam a series of "scan coils" steers the beam around the sample. By determining the voltages to apply to the scan coils it is possible to position the beam anywhere in the field of view. It is this feature that can be used to produce ion-milled structures such as rectangles, circles and so on. The beam then mills the whole of this defined area under constant conditions (fixed ion dose), with typically many thousands of passes of the ion beam. The depth of the milled shape is then defined by the beam conditions and the number of passes. It is this feature that results in the flat-bottomed milled features. What 'conventional' ion milling does not do is attempt to produce complex surfaces such as curves and textures. It is this limitation that the proposed methodology attempts to address.

<u>Explanation as to Terminology Used in this Specification</u>

By milling rate we mean the amount of material that will be removed by the ion beam under a given set of beam conditions, in a given time. It can be assumed that multiple passes of the beam will remove substantially the same multiple of material as a single pass. The beam conditions referred to are: i) the beam current (which can be thought of as the number of ions in the beam in a given time); ii) the spot size of the beam (the diameter of the focused beam on the sample surface, this is intimately linked to the beam current); iii) the beam dwell (the amount of time the beam resides in a fixed position on the sample surface); iv) the step size (the size of step the beam makes as it passes over the sample (this is generally referred to as beam x and y pitch). The movement of the beam is a series of steps of x and y pitch, with the beam stopping at each step for the duration of the beam dwell; v) the beam overlap (this is simply a function of the spot size, and step). For example a 100 nm spot with a 50 nm step would result in a 50% overlap; and vi) the number of passes (simply the number of times the beam revisits the same location on the sample).

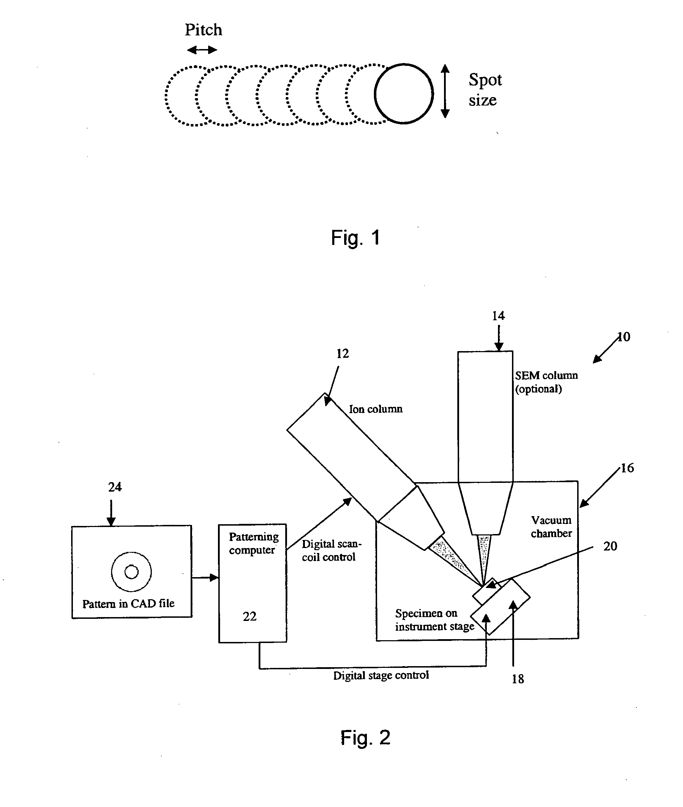

A simple illustration of pitch and spot size is given in Figure 1, which is a schematic diagram of beam overlap showing pitch and spot size.

The method and system taught herein extends two dimensional ion milling to be able to produce complex three dimensional structures with very high resolution and accuracy, by determining and using the milling rate of the chosen material. The preferred embodiments taught herein exploit the use of additional software and hardware that comprises an electron beam lithography system modified to drive the scan coils of an ion column instead of the usual electron column. Electron beam lithography can be thought of as a similar process in that the electron beam is steered around a sample coated with a resist that is cured by the electron beam dwelling for a given time at each point in the pattern. Such systems allow for far more complex patterns than the simple pattern generators provided by manufactures of focused ion beam instruments. Also these (e-beam) patterns can be drawn in CAD programs enabling much higher complexity and productivity.

A schematic diagram of a preferred embodiment of instrument is shown in Figure 2.

The instrument 10 is provided with an ion column 12 and, optionally, a scanning electron microscope (SEM) column 14. The ion and SEM columns 12 and 14, feed into a vacuum chamber 16 in which there is located an instrument stage 18 upon which a specimen 20 to be milled is placed. A patterning computer 22 is able to control the ion column 12 and the optional SEM column 14, as well as the movement of the instrument stage 18, thereby to control the milling of a specimen 20 located in the instrument 10. The instrument also includes a pattern input unit for feeding into the patterning computer 22 a three dimension pattern to be milled on the specimen 20. In this embodiment, the pattern input unit 24 provides a CAD file with a pattern to be milled stored thereon.

The system makes use of the milling rate of the chosen substrate material and the development of three-dimensional patterns based on the milling rate for that material for the lithographic pattern generator.

The milling rate for a given material is determined in the preferred embodiment by milling a plurality of simple square geometry patterns of a few micrometers side length in the material of choice, and then by measuring the milled depths with an atomic force microscope (AFM) to determine the volumes of material that have been removed. As the combined range of beam currents, pitches, dwells and number of passes is almost infinite, it is impractical to produce a milled square for every variable. However, the preferred embodiments adopt a few shortcuts that can be exploited to arrive at a milling rate in quick order. Assuming the user has a reasonable understanding of the use of the ion beam instrument it will be within the ability of that skilled person to estimate a sensible range of likely beam values that should give the desired result. For example, the typical range of ion beam currents is from 1 pA to 20 nA. Broadly this range can be applied to the size of the desired feature. An experienced user would not contemplate milling a 100 nm structure at 20 nA (beam spot size is approximately 425 nm at this current). Similarly one would not mill a $100\mu m$ structure at 1 pA. Also with regard to pitch, the experienced user would aim to achieve a few 10's of percent overlap in the beam to ensure complete removal of material in the desired area. Therefore, a skilled user could generate a suitable calibration result by producing just a few examples of milled squares. In addition to this, continued use of the system of Figure 1 can be used to create a database of milling conditions for different materials and in the best case only a single specimen milled box might be needed to confirm the calibration.

Such calibration can be used to generate a simple look-up table of material types and milling rates dependent upon beam intensity and duration. Thus, such a look-up table would provide a range of milling rates under different beam conditions for each material, and would recommend beam conditions for certain milled pattern criteria, such as volume to be removed, size of smallest feature and so on.

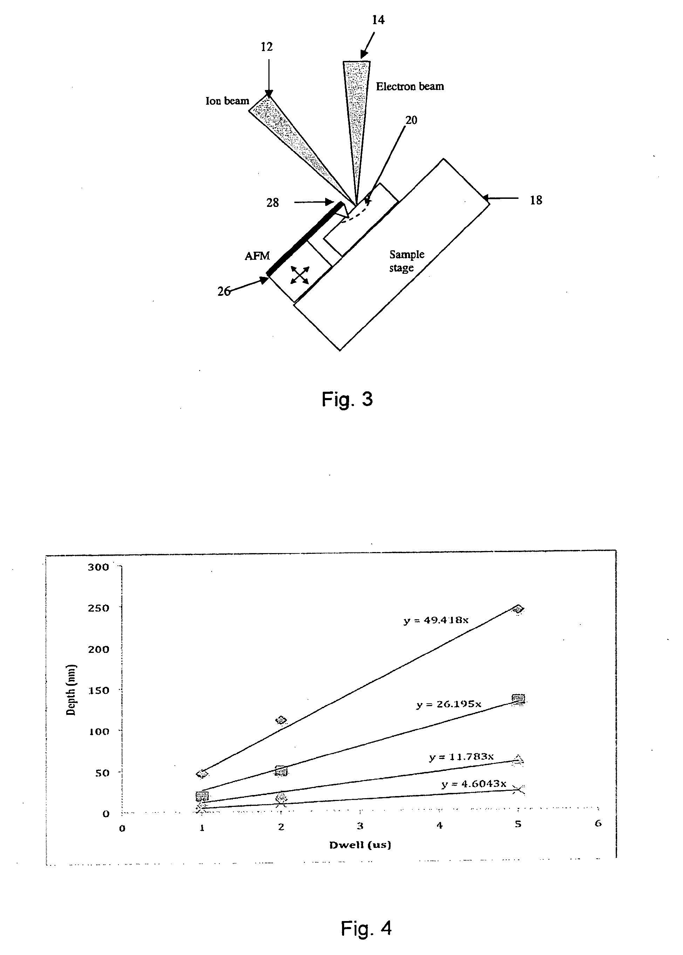

The preferred embodiment may also include an AFM (atomic force microscope) in the ion beam chamber, so that the calibration could be done *in-situ,* or even with feedback from the AFM, so that the system can effectively be calibrated in real-time as the sample is milled to its final geometry. An illustration of an AFM combined with the specimen stage is shown in Figure 3.

Referring to Figure 3, the embodiment shown includes an ion beam column 12, an electron beam column (SEM column) 14 and sample stage 18 as an embodiment of Figure 2. It will be appreciated that the sample would be held within a vacuum chamber 16 and that movement of the sample stage as well as of control of the two columns 12 and 14 would be effected by means of a patterning computer 22 and to the control of a patterning input 24. In this embodiment, there is provided on the sample stage 18 an atomic force microscope probe 26 which includes a probe tip 28 which is able to measure the amount of milling of the specimen 20 substantially at the time at which it is being milled. Or course, in practice the AFM tip 28 will lag slightly the point of milling and even so it is envisaged that reading from the atomic force microscope 26 will be substantially simultaneous with the actual milling action, in other words to be effectively in real time.

The readings from the AFM tip 28 are supplied to the patterning computer 22 which can determine therefrom the actual rate of milling of the sample 20 based upon the particular beam characteristics from the two columns 12 and 14 (in the case when the option column 14 is included). Thus, the beam characteristics of the columns 12 and 14 can be adjusted in order to adjust the rate of milling and thus the three dimensional pattern produced in the sample 20.

It is envisaged also that the readings of the AFM tip 28 could be used in a correlation with milling data in a lookup table in the patterning computer 22 in order to calibrate this not only for the current milling stage but also for subsequent milling stages.

A system as depicted in Figure 3 can provide a means for producing calibration data on the sample material of choice. Indeed, with care it is possible produce the final desired milled shape on the actual sample 20 using the AFM 26 to provide feedback of the milling rate.

It is envisaged that is some embodiments the AFM tip 28 could be located at the precise position where the beams 12 and 14 mill the sample 20, rather than lagging any movement of the beams 12, 14. In such an embodiment, it will be appreciated that there will be provided a mechanism to retract the AFM head 28 from the beam path during milling. This would be followed by a pause in the pattern where the AFM head 28 would be inserted and a measurement of the milled volume taken. The AFM head 28 would then be retracted and milling could be resumed when the milling model had either been verified, or corrected, to produce the desired milling rate.

Other embodiments make use of an external AFM. However, such an embodiment is not preferred as it would involve the need to move the sample 20 to the external AFM, which would need to be aligned on the AFM for each measurement and then would have to be realigned for further milling in the specimen chamber 16. Milling the same region following realignment in the specimen chamber 16 would be prone to error. It is envisaged that alignment marks could be pre-patterned into the sample, although so doing would increase the time taken to mill the volume as whole.

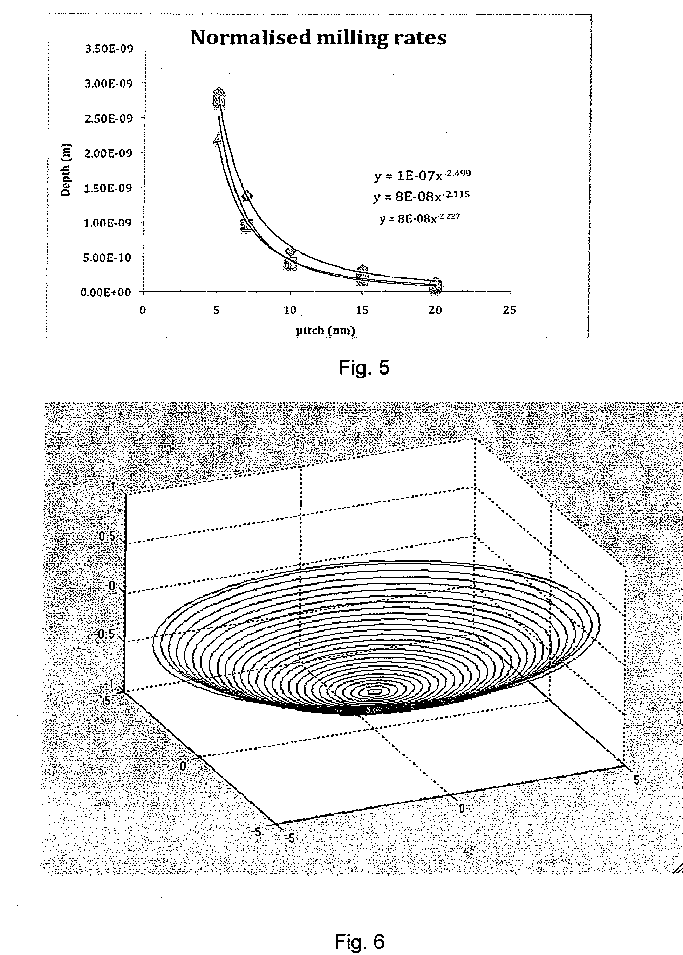

In a practical example, assuming we want to mill a volume of a $10\mu m$ square and 300 nm deep in pure single crystal silicon, an experienced user might choose to use 100pA as a beam current. As the spot size is fixed by an aperture that limits the beam current to the required value, a typical beam spot size at this current would be about 23 nm. Milling a series of calibration squares $1\mu m$ in side length at 100pA and varying the other parameters such as dwell time, passes and pitch would produce the data shown in Figures 4 and 5.

Figure 4 is a plot of milled depths at 100pA for a range of calibration conditions. The diamond points represent milling at 5nm x and y pitch, the square points 7nm pitch, the triangle points 10 nm pitch and the crosses 15nm pitch.

As can be seen in Figure 4 milling twelve squares with varying dwell and pitch has yielded four milling rates. As the dwell changes is can also be seen that the milling rate varies linearly, which simplifies the model of the milled volume considerably, and confirms that milling depth varies linearly with number of passes. The dwell in fact only scales linearly over a limited range, but this is the most likely to be used for the milling process. Should it be necessary to extend into the non-linear range, a simpler option is to increase the beam current or number of passes.

Turning to the effect of pitch, the milled depth does not scale linearly with changing pitch, as can be seen in Figure 5. Again relying on knowledge of suitable beam conditions calibration can be simplified considerably and for a given beam current of 100pA we would choose a pitch in the range 12 to 18 nm. The reason for this is that at 100pA the spot size is 23 nm so a pitch in this range would give an overlap of about 50 to 75%. In this case as we have calibration data at 15 nm we will use this corresponding to an overlap of about 65%.

In Figure 5, there is shown a normalised plot of milled depths at 100pA for a range of beam conditions. The diamonds represent milling at 2us and 10 passes, squares $2\mu s$ and 20 passes and the triangles $2\mu s$ and 50 passes. All data has been normalised for a single pass.

Now, with an accurate value for the milled volume under a chosen set of conditions it is possible to proceed to produce the pattern required for three-dimensional milling.

To produce accurate three dimensional structures there are described below approaches to pattern generation. As stated above, the preferred embodiment for patterning is a modified electron beam lithography system. Using this system one can adopt two different methodologies to produce patterns suitable for three-dimensional milling. The first is to use a "nested pattern" the second is to use the RGB values in a bitmap image.

To explain the nested pattern approach the example of generation of a parabolic dish is used. Assuming one wants to produce, in Silicon, a dish of diameter $10\mu m$ and with a focal length of 10 $\mu m$, this would result in a dish of depth 625 nm with parabolic curvature following the form $y = ax^2 + c$, where y is the depth and $a$ and c are constants associated with this particular dish. Using MATLAB code to perform all calculations, if one think of the dish as being a series of stacked and nested milled cylinders with a common centre of radius as shown in Figure 6, the height of each cylinder will follow the equation shown above. To determine the number of cylinders the function:

$$\text{number of cylinders} = 10 + \text{round}((\text{diameter} - 1)/0.5)$$

is applied to give one every 100 nm for $1\mu m$ diameter, or 10 plus one for every 500 nm over $1\mu m$. This function has been derived through a trial and error approach, but found robust. In the case of a $10\mu m$ diameter parabolic dish this gives 28 cylinders. By drawing in CAD package 28 nested circles with each circle either drawn on a separate drawing layer, or optionally in the case of software a different colour, one can define a set of milling parameters that will mill out a cylinder of material corresponding to the depth of each circle in turn.

As the model calculates the number of circles it also calculates the depth of each circle that follows our parabolic equation, from the inner most circle outwards, as follows:

Depth in nm 0.797194
Depth in nm 2.391582
Depth in nm 3.985969
Depth in nm 5.580357
Depth in nm 7.174745
Depth in nm 8.769133
Depth in nm 10.363520
Depth in nm 11.957908
Depth in nm 13.552296
Depth in nm 15.146684
Depth in nm 16.741071
Depth in nm 18.335459
Depth in nm 19.929847
Depth in nm 21.524235
Depth in nm 23.118622
Depth in nm 24.713010
Depth in nm 26.307398
Depth in nm 27.901786
Depth in nm 29.496173
Depth in nm 31.090561
Depth in nm 32.684949
Depth in nm 34.279337
Depth in nm 35.873724
Depth in nm 37.468112
Depth in nm 39.062500
Depth in nm 40.656888
Depth in nm 42.251276
Depth in nm 43.845663

As can be seen, the depths of each circle increases following the parabolic equation, indicating that the curve is steepest at the other edge of the dish and shallowest in the centre, as should be the case. Now that we have the depths for each circle a dwell can be defined based on the 100 nA beam and 15 nm pitch to produce the milled concentric circle at the correct depth. However, it is necessary also to assign a number of passes, as milling in a single pass is very prone to re-deposition of the milled material and inaccuracy of the final structure. The following formula can be used reliably for relatively shallow structures:

$$passes = round \, (10 + (depth - 1)/0.1)$$

This states that if the total depth is less than $1 \mu m$, 10 passes are used, and then one extra pass is used for every 100 nm of extra depth. Some revision would be needed to this model for milling particularly shallow or very deep structures.

Having the number of passes set, and the milling depths, the required beam dwell times can be calculated to produce the structure dish. Again using MATLAB code in this example, one can calculate the dwell time for the given beam current, pitch and number of passes as shown below:

number of passes 10
Milling time in us 0.731
Milling time in us 2.194
Milling time in us 3.657
Milling time in us 5.120
Milling time in us 6.582

Milling time in us 8.045
Milling time in us 9.508
Milling time in us 10.971
Milling time in us 12.433
Milling time in us 13.896
Milling time in us 15.359
Milling time in us 16.822
Milling time in us 18.284
Milling time in us 19.747
Milling time in us 21.210
Milling time in us 22.672
Milling time in us 24.135
Milling time in us 25.598
Milling time in us 27.061
Milling time in us 28.523
Milling time in us 29.986
Milling time in us 31.449
Milling time in us 32.912
Milling time in us 34.374
Milling time in us 35.837
Milling time in us 37.300
Milling time in us 38.763
Milling time in us 40.225

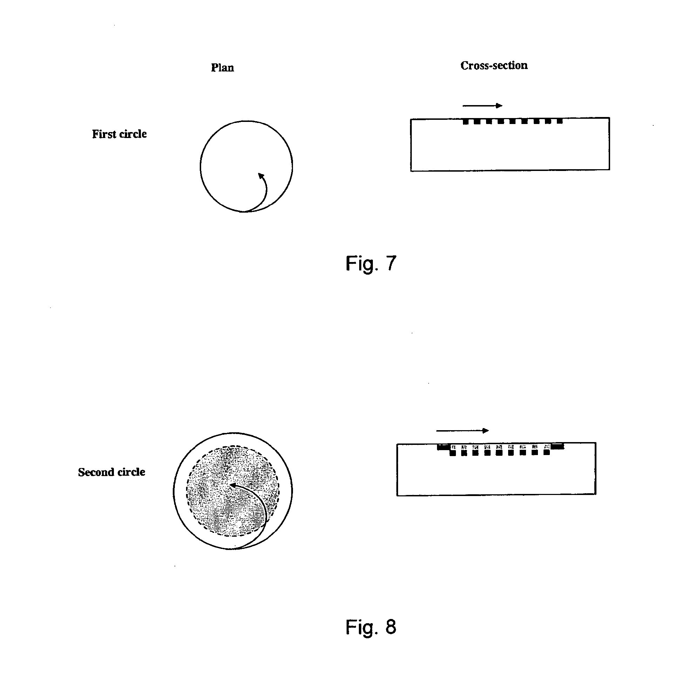

This gives all the data needed to apply to a lithography program to mill twenty eight concentric circles of decreasing depth to produce a parabolic dish of the desired focal length. A well informed reader may think that the above strategy would give rise to a stepped dish and not one with a smooth surface. This is incorrect as the preferred embodiment adopts a strategy to produce a smooth surface from a series of milled nested entities. In the case of the parabolic dish if the milling is carried out in spiral motion from the outside edge of the smallest circle to the centre, and then the second circle is milled, and then the third and so on in a similar manner, the beam constantly mills over the small stepped outside edge of the last circle. This is shown in Figures 7 and 8.

In Figure 7, the first circle (first pass) is milled from the outside edge of the first circle in a circular motion of the beam. Preferring now to Figure 8, the second circle (in the first pass) is also milled from the outside edge in a circular motion of the beam and this over-rides the first circle, shown in grey in Figure 8. This process is continued for the preferred number of cycles and number of passes.

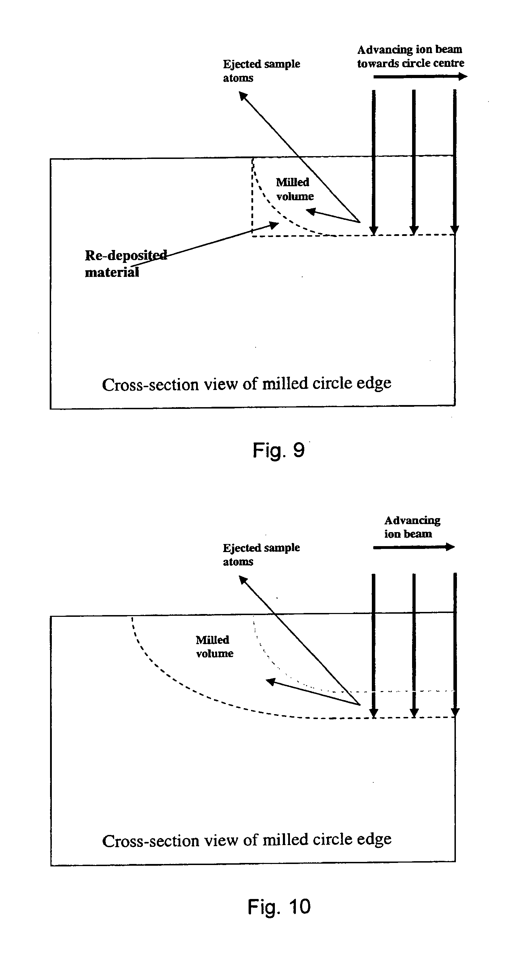

Furthermore, milling in this manner re-deposits some material behind the beam as it passes. This has the effect of filet radiusing the outside edge of the milled circle. It should also be remembered that the pattern will be set up so that the circles are milled many times to achieve the correct depth. Therefore each circle is only a few nm deep with each pass. The combination of the very shallow milled circle and the re-deposition process has the effect of smoothing out the steps without giving rise to any dimensional errors. This is demonstrated in Figures 9 and 10.

With reference to Figure 9, even though a near 90° edge is initially milled by the beam as it moves from the outside edge of the circle to the centre, a smaller amount of material piles up behind the beam and creates in effect a "filet radii" corner. Referring now to Figure 10, as further, larger, circles are milled over previous circles, the existing filet radius gets milled away but material still re-deposits along the edge of the circle being milled. This has the effect of removing the steps that will be present from a series of concentric milled circles.

Nested patterns of other two-dimensional shapes could also be milled in a similar method where the outermost edge is milled first with the beam moving in towards the centre of the pattern.

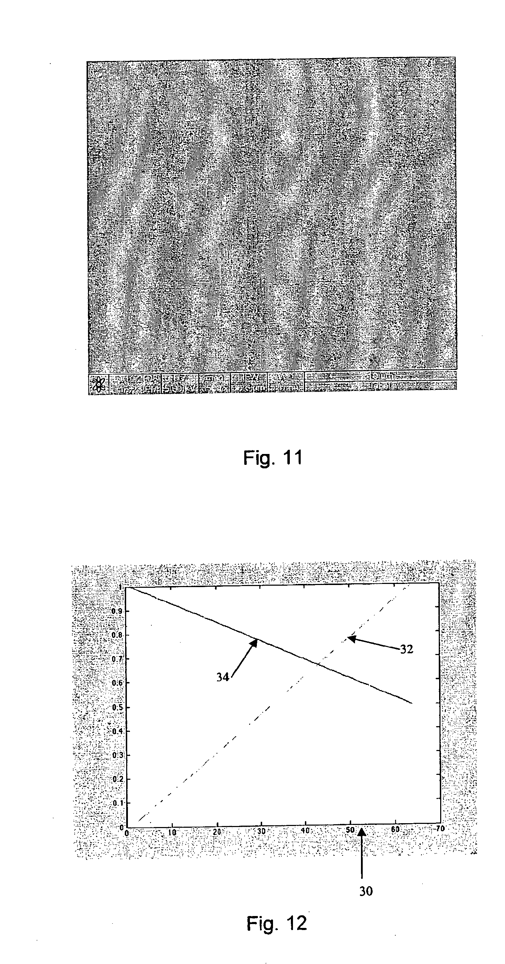

Figure 11 shows an electron micrograph of a series of four parabolic mirrors of different focal length milled in this way. As can be seen, the mirrors are indeed smooth. Further testing with both confocal microscope and optical methods have shown these dishes to be dimensionally very accurate. Indeed, the optical method is a non-direct method where the focused spot is imaged, and if the dishes were of poor dimensional accuracy no such focused spot would be present. A further method of smoothing out the step edges is to very slightly understate the milling dwells for each circle but then add on a single pass over the whole structure that mills away the difference over the whole shape. This also achieves a similar effect but tends to require little trial and error to get the highest accuracy.

The use of nested pattern milling is ideally suited to regular geometries such a parabolic dishes, cones, pyramidal indents and so on, but is not ideally suited to more arbitrary surfaces. For this reason a second strategy has been developed where any mathematically defined surface or 3-dimensional surface data can be reproduced on scale lengths similar to the parabolic dishes described above.

A second embodiment of method has been developed where a surface plot of either a mathematical function or surface data can be milled into a substrate is now described. Using a mathematical computer code such as MATLAB one can produce a 3-D surface plot. This can then be used to define what is called a colour map to express the height in the plot, which can then be converted into an RGB bitmap that can directly read the bitmap into the lithography software for milling.

MATLAB provides quite a few colour maps. These are variations of an RGB image where the R,G,B values are limited in their range. For example Figure 12 shows the MATLAB colour map 'winter', in which Red plot 30 is flat over the whole range, with Green 32 and Blue 34 varying linearly. This means that any image converted to use this colour map will not have any red component in the final image. Conversion involves taking the RGB value at every pixel in the image and multiplying by a conversion factor to produce the new image, or in the case of 2-D plot of 3-D data the Z height can be represented by increasing the value of one RGB component.

There are many other colour maps that do similar things by changing the R, G and B respectively.

The method involves converting the surface plot into a new colour map, using the G (green) value of every pixel (in the case of this particular colour map) and assigning a depth (Z) to it as it varies over the range. That is, when G is 255 it has zero depth when G is 0 it has a depth defined by the user. So if we have G/2, we have Z/2 and so on. It is also possible to define the resolution in the colour map by using rounding functions to produce as many levels of depth as desired up to a maximum of 256.

To demonstrate this, a standard MATLAB "demo" called 'square waves from sine waves' is used. This is a demonstration showing the Fourier series expansion for a square-wave is made up of a sum of odd harmonics, known as the Gibbs effect. For example, this series would be expressed as:

$$y = \sin(t) + \sin(3*t)/3 + \sin(5*t)/5 + \sin(7*t)/7 + \sin(9*t)/9\ldots$$

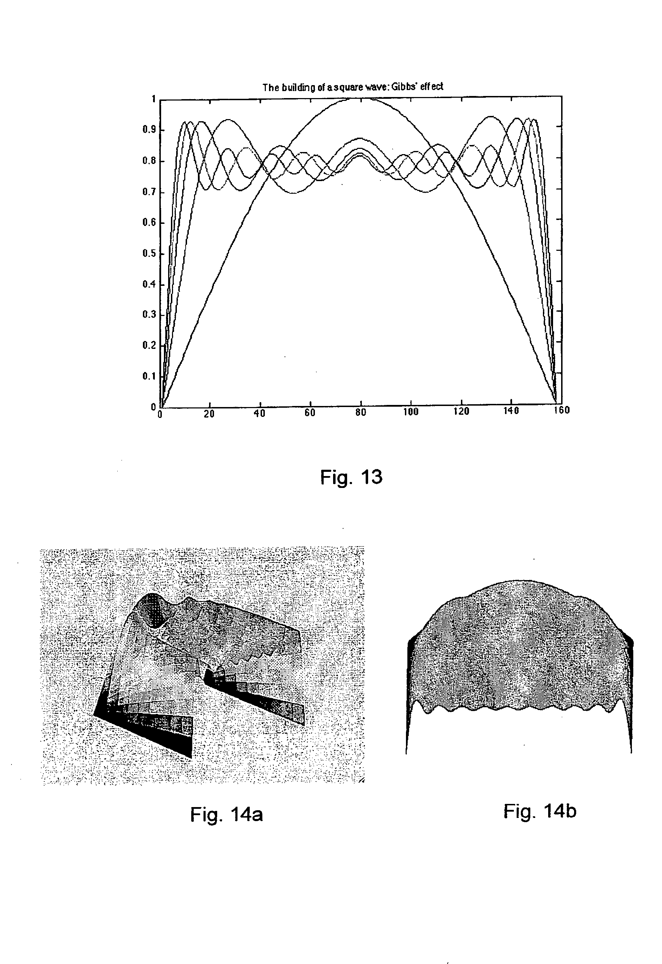

When plotted as a 2D plot for the first 19 harmonics it can be seen in Figure 13.

Creating a 3D plot of this one can graphically show the transition from Sine wave to square wave for the first nineteen harmonics in the series. Also shown in Figures 14a and 14b is the same plot assigned the colour map "winter" and rotated a little to further demonstrate the topography. The green component in the image increases with increasing Z height, whereas the blue component decreases.

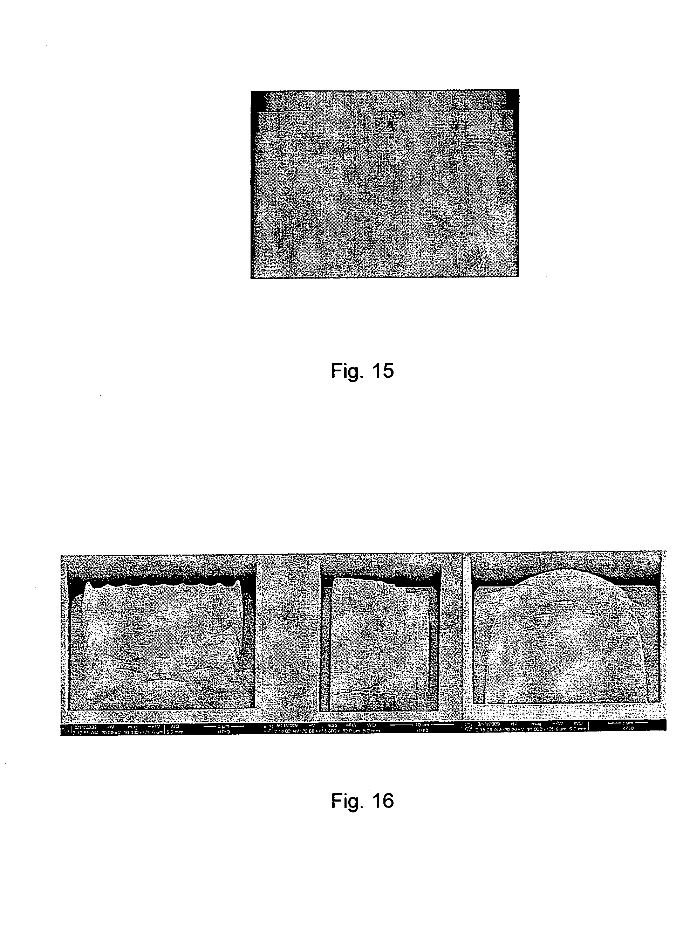

Now, converting the plot back to a 2D plot, that is taking a view from directly above, one can create a 2D bitmap image where the topographic height is denoted by the RGB values of each pixel in the image, as shown in Figure 15. The image gives an intensity distribution in Green and Blue which denote height.

Now with an image we can assign a function to one of the RGB values (in this case G) based on depth and can then set the doses and mill the desired volume. Just to reiterate, in the image what appears as fully green has zero depth, and what appears as fully blue (i.e. no green) has the depth set by us as the maximum milled depth. The green content of each pixel is then taken to indicate the depth over the range of 55 shades of pixel (in this case). In other words the maximum depth is divided up into 55 equal steps from zero to maximum specified depth. In the lithography software we can now import the bitmap, and assign a dose (based on the milling rate of the material) to each pixel shade based on its RGB values. We could of course use other colour maps and choice of either R, G or B. In this case the reason the MATLAB 'winter' colour map was used is due to the linear change in the G value of the whole range.

One final parameter needs to be considered before milling this pattern, which is the step size. Again based on the calibration data the size of the bitmap image would ideally be scaled to be an integer multiple of the step size. Using a 15 nm step as before, we could choose to make each pixel 15, 30, 45 nm etc. This needs to be taken into consideration when designing the original pattern data but many simple interpolation functions exist in image manipulation packages that could scale the pixel size of the image to be the desired size. For example if the milled structure were 10 x 10 $\mu$m and we used a 15 nm step we would scale the image to be 666.6 pixels wide and high. Of course one cannot have a fraction of a pixel in the image so we would change the step size to 12.5 nm, and calibrate the milling rate for this step size, or assume a very small error for a 15 nm step by using 666 or 667 pixels wide and high, resulting in a milled area that would be 9.99 or 10.005$\mu$m wide and high. One could also of course multiply the pixel number by an integer and reduce the error for a 15 nm step, for example 2667 pixels wide and high. This is likely to beyond the resolution error of the instrument and so could be thought of as accurate for the technique.

Figure 16 shows a series of SEM micrographs of the milled pattern in Silicon. As can be seen, the original data has been reproduced but with the detail at the nanometre scale. In this example, we have also prevented the pattern from milling to the full depth by reducing the bitmap image width slightly, and have milled a frame around the structure for clarity in the SEM. It should be noted that the views in Figure 16 have been tilted with respect to the beam to show better the milled topography.

The above-described embodiments assume that the process commences with a flat surface such as a silicon or quartz wafer. One of the limitations of such a technique is that it is sequential, that is one structure at a time can be processed for each milling beam which is provided. This of course is slow, although remains technologically important.

For the production of a large array of similar structures, there are currently two preferred routes of manufacture. On method could make a small array which is then turned into an imprint stamp. This stamp can then be used to make a larger array, and so on, until there is produced a final array of the size required. There might be some loss of dimensional accuracy at each step, but if this were tolerable it could easily be done. One possible weakness with this approach is if a large non-regular array is required, either in terms of spacing or size of each feature in the array. This would be difficult to achieve by producing a minimum array as a stamp and then scaling this up.

Another preferred method, whether for a regular or a non-regular array, is to remove some of the required volume using a conventional etch technique and then produce the finished shape using the 3-D milling techniques taught herein. This would produce a roughed out array in parallel which can then be finished by sequential milling.

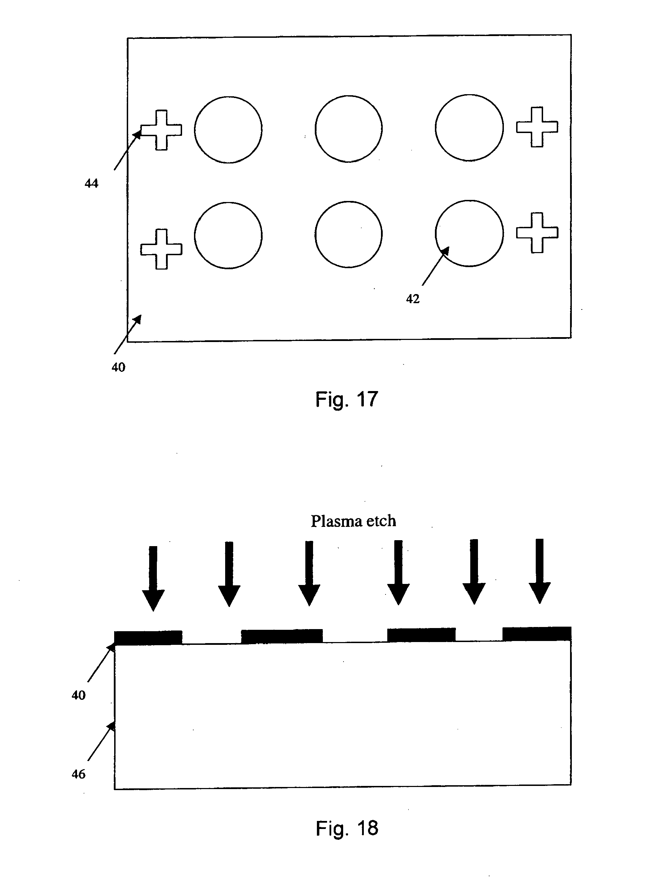

An example of a combined conventional etch step followed by a 3-D milling stage is described below in connection with Figures 17 to 20. This example creates an array of parabolic dishes.

The method includes the following primary steps:

i) a conventional mask is produced for optical lithography. This mask would typically consist of circles and alignment marks;

ii) the mask is then used to cure a resist which is used either as an etch-stop or for subsequent deposition of a metal film to be used as an etch-stop. The circular patterns form holes in the etch stop and are therefore exposing uncovered wafer material;

iii) using for instance an inductively coupled plasma (ICP) etcher, the holes etched through for a given time. This type of etch gives very good vertical sidewalls and the etching rate can be controlled very accurately. This will produce an array of flat-bottomed etch holes that can subsequently be milled to produce the final desired shape.

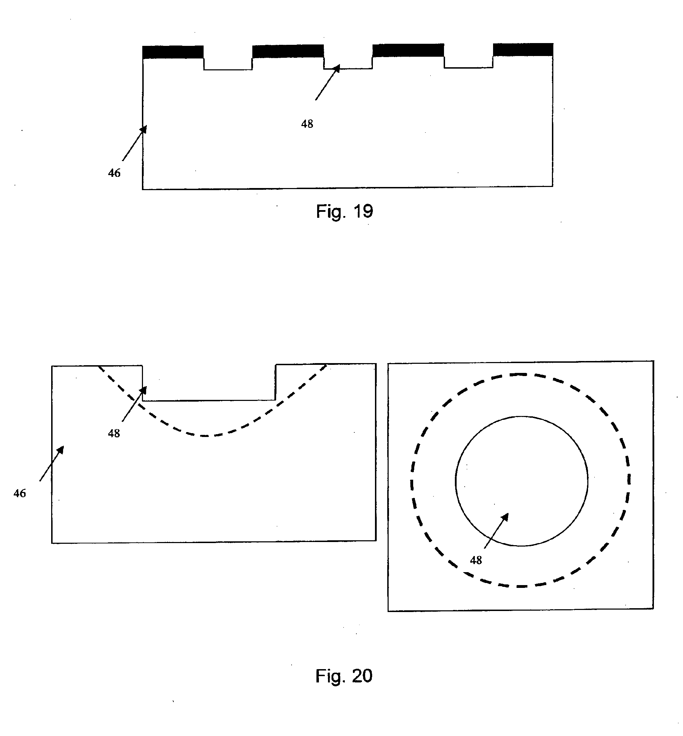

Figure 17 shows an example of a simple mask 40 for producing an array of six roughed-out parabolic dishes 42. The mask is provided with a plurality of alignment marks 44. The mask is placed on a wafer substrate 46 to be treated, as shown in Figure 18. For the sake of simplicity, the alignment marks 44 are not shown in Figure 18. The wafer substrate 46 is etched in a conventional manner so as to produce an array of roughed out pits 48 corresponding to the apertures of the mask 40. Figure 20 shows a cross-sectional view in side elevation as well as a plan view of one of the pits 48 etched in the wafer substrate 40 with the dashed lines showing the desired final shape of the parabolic shaped structures. These structures are produced by milling the etched out pits by the methods disclosed herein. It will be appreciated that the subsequent milling steps will be controlled and carried out having regard to the extent of the pitting in the surface of the substrate, the latter being determined empirically or by measurement using, for instance, atomic force microscopy.

In one practical method it is preferred to obtain a determination of the exact shape and depth of the pre-etched pits 48. Fortunately ICP does tend to produce very straight sided and flat bottom holes, and this should not be a worry. Also one can expect very good agreement from hole to hole in all aspects if done in the same run. With careful lithography the x and y dimension of the pits can be reproducible with very high accuracy. It may nevertheless be preferred to obtain a measure of the final (z) depth of a small number of pits 48 to establish this dimension. This can be readily achieved with any suitable aerial measurement techniques. Alignment will be achieved with appropriate fiducial marks located on the surface. With modem instrument stages it is only necessary to have such marks at only a few points on the sample 40 and not for every pit 48.

The modifications to the pattern are in principle be-straightforward. In most instances all that is necessary is a subtraction of the hole volume from a pattern designed for a flat surface.

The above-described etching method can also be extended to the use of multiple masks, grey-scale masks, to produce nested holes for the IPC etch. This could be considered as a crude version of the strategy disclosed above for ion milling. This crude stage can be used to remove more volume and reduce ion milling time further. Again, prior to ion milling a measure could be obtained, empirically or by measurement, of the size and shape of the pits produced in order to adjust the ion milling parameters in order to produce the final desired milled structure.

It will be apparent that the above embodiments provide means for determining or obtaining a milling rate of the material of the device based upon the ion beam strength, ion dwell time and the nature of the material to be milled. The necessary means, which could be a device or a methodology, could be described as a diagnostic system or unit.

In the above described embodiments and Figures, there have been shown primarily structures which are symmetrical about the planar axes. This has been done solely for simplicity of description. The methods and systems taught herein are equally able to produce non-symmetrical three-dimensional structures. These can be produced by varying the milling passes, in terms of number, position and lateral extent. For instance, in some applications it might be desired to produce an off-axis mirror or lens, which can readily be achieved by milling in an off-axis sequence, for instance. The skilled person will appreciate that complex three-dimensional structures can be produced by using the taught milling techniques, including irregular patterns and shapes.

The above described embodiments address the production of a three dimensional structure. In some instances it may be desired instead to produce by the above methods a replica or mirror image which is then used to make the desired structure. The manufacture of such replicas for the production of three-dimensional structures formed of materials for which a milling rate cannot be reliably or easily determined. An example of such a material is metallic films. These are known to mill very non-uniformly due the random orientation of the individual grains in the film. The different orientations with respect to the ion beam results in very different milling rates for each grain orientation. Even when starting with a flat film and attempting to mill a flat bottom, the flatness very quickly deviates due to the grain orientation. Another example of a difficult material is a dielectric, where sample charging can lead to drift in the ion beam, resulting in errors in the final milled structure.

To produce surfaces in 'difficult' materials such as those described here, or to scale the process to large volume production a simple step, would be the use of nano-imprinting. In this process a stamp or mould is pressed into a photoresist material such as PMMA deposited on a substrate. The mould and substrate are then cured by either a heating process or exposure to a particular wavelength of radiation. Once cured the mould is removed, leaving behind an imprint in the resist. This imprint can then be used as a further mould or stamp, or could be coated with a material that can in turn be released, leaving behind a surface of the originally milled master. Such a process could use either of the following steps. A negative master is made in a suitable material (for example, silicon), a positive replica is made of this, or alternately a positive is made in silicon and then a negative replica is made, finally a material is coated onto the negative and then released making a positive again in the material of choice.

A further example of the replica technique could be in making micro lenses in a suitably transparent material. A series of parabolic dishes could be milled in silicon and then a PMMA film (PMMA having excellent optical properties) of the correct thickness deposited over the substrate. The PMMA would then be cured by the application of heat and released from the substrate. The released PMMA film would then be made up of an array of lenses.

There is a wide variety of applications for three-dimensional structures made by the above-described methods, some of which are disclosed below.

One application is in the manufacture of very precise microscope standards or test specimens for many different types of optical, electron and scanning probe microscopes. In each case, a different geometry might be necessary, or ideally a single unified standard might be produced, comprising a range of structures such as very precise gratings, steps and slopes. Presently almost all standards for microscopic techniques are made by lithographic and etching or deposition processes, resulting in very limited geometries.

As mentioned in the method, the fabrication of very precise micrometer lenses and mirrors might find a wide range of uses in photonic applications such as optical computing, fraud prevention, or other photonic applications such as wave-guiding for optical communications with MEMs devices and computer chip to chip applications. Indeed we are presently investigating the use of the parabolic mirrors for applications of atom and ion trapping leading to uses in Qbit applications in quantum computing. In this application an array of off-axis mirrors is used to focus light from a single laser beam into multiple beams with well-defined foci that form a box capable of trapping individual atoms or ions. A similar array of off-axis mirrors could form the basis of an optical tweezers device.

Applications for these structures could also be in the growing areas of scientific interest that are plasmonic devices and structured materials (Meta Materials). In these devices and materials, a combination of material and surface morphology leads to unusual properties such as negative refractive index, light slowing or confinement, light enhancement or exclusion, and opens the possibility of optical computing amongst other things.

The teachings herein may also be used in the production of superlensing, that is in the production of an array (for example 10x10) of lenses either milled directly into glass (or similar) using the milling technique, or formed within a mould that is itself milled using the 3d milling technique taught herein. Such an array can be used in a far-field optical microscope capable of reaching nanometer-scale resolution. The lenses can work as a parabolically shaped dielectric layer for scattering light.

Finally there may be a significant market for custom made stamps for nano-imprint. Indeed, presently custom-made stamps for this technique can command several thousand Euros per stamp.

## Claims

1. A method of milling a three-dimensional form for the production of a three-dimensional structure in an article (20), including the steps of:

   determining a milling rate of a material to be milled in dependence on ion beam strength and dwell time; and
   milling by means of ion beam milling an article made of said material on the basis of the determined milling rate, wherein the milling step mills adjacent areas of the article at different depths to produce a shape varying in three dimensions; the method being **characterised by** the steps of:

measuring actual milled depth within a milled structure; and

adjusting milling intensity and/or milling dwell time on the basis of the measured milling depth.

2. A method of milling according to claim 1, wherein the milling step comprises a plurality of milling passes, the method including the step of milling at least one following pass in the plurality of passes over a region milled in a previous pass.

3. A method according to claim 2, wherein said following milling pass mills over a part of a previous milled pass.

4. A method of milling according to any one of claims 2 or 3, wherein at least some sequential milling passes are milled concentrically, and/or wherein at least some sequential milling passes are milled non-concentrically.

5. A method according to any preceding claim, wherein the ion beam intensity and/or the milling dwell time is set for individual passes of a plurality of milling passes within the milling step.

6. A method according to any preceding claim, wherein milled depth is measured by means of an atomic force microscope (26).

7. A method according to any preceding claim, wherein milling depth is measured during the step of milling.

8. A method according to any preceding claim, wherein the depth of milled area is measured prior to milling a subsequent area within the milling step.

9. A method of milling according to any preceding claim wherein the method mills a three-dimensional article.

10. A method of milling according to any preceding claim, including the step of effecting at least one etching pass over said article to produce an array of pits and milling said pits to produce an array of said three-dimensional structures.

11. A system (10) for milling a three-dimensional pattern in a device (20), including:

an ion column (12) operable to generate an ion beam able to mill an object;
a diagnostic system for determining or obtaining a milling rate of the material of the device based upon the ion beam strength and ion beam dwell time;
a control unit (22) for controlling the ion column (12) on the basis of the determined milling rate and three-dimensional pattern to be milled;
wherein the control unit (22) is operable to mill adjacent areas of the device (20) at different depths so as to produce a three-dimensional milled pattern; the system being **characterised by**:
a measuring device (26) for measuring actual milled depth by the ion column (12), the measuring device (26) being coupled to the control unit (22) in a feedback manner and the control unit (22) being operable to adjust the milling intensity and/or milling dwell time on the basis of the measured milling depth.

12. A system according to claim 11, wherein the control unit (22) is operable to control the ion column (12) to mill the device (20) in a plurality of milling passes.

13. A system according to claim 11 or 12, including a database of milling depth, beam intensity and beam dwell time for one or more materials, wherein the database is in the form of a look-up table.

14. A system according to any one of claims 11 to 13, wherein the measuring device (26) includes an atomic force microscope tip (28).

15. A system according to any one of claims 11 to 14, including an SEM column (14), and/or including a vacuum chamber (16) for holding a device (20) to be milled, and/or including at least one etching mask (40) and an etching station for effecting at least one etching pass over said article to produce an array of pits (48) prior to milling said pits to produce an array of said three-dimensional structures.

16. A device having a three-dimensional pattern or structure milled by a system according to any one of claims 11 to 15.

**Patentansprüche**

1. Verfahren zum Abtragen einer dreidimensionalen Form zur Erzeugung einer dreidimensionalen Struktur in einem Gegenstand (20), mit folgenden Schritten:

   Festlegen einer Abtragsgeschwindigkeit eines abzutragenden Materials in Abhängigkeit von der Stärke eines Ionenstrahls und einer Einwirkdauer; und
   Abtragen mittels eines Ionenstrahlabtragens eines aus dem Material hergestellten Gegenstands auf der Grundlage der festgelegten Abtragsgeschwindigkeit, wobei der Abtragsschritt benachbarte Bereiche des Gegenstandes in unterschiedlichen Tiefen abträgt, um eine in drei Dimensionen variierende Form zu erzeugen;
   wobei das Verfahren durch folgende Schritte gekennzeichnet ist:

   Messen des Istwertes der abgetragenen Tiefe in einer abgetragenen Struktur;
   und
   Einstellen der Abtragsintensität und/oder der Abtragseinwirkdauer auf der Grundlage der gemessenen Abtragstiefe.

2. Verfahren zum Abtragen nach Anspruch 1,
   in welchem der Abtragsschritt mehrere Abtragsarbeitsgänge aufweist, wobei das Verfahren den Schritt des Abtragens von mindestens einem anschließenden Arbeitsgang von den mehreren Arbeitsgängen über einen Bereich einschließt, der in einem vorhergehenden Arbeitsgang abgetragen ist.

3. Verfahren nach Anspruch 2,
   in welchem der anschließende Abtragsarbeitsgang über einen Abschnitt eines vorangegangenen Abtragsarbeitsgangs abträgt.

4. Verfahren zum Abtragen nach einem der Ansprüche 2 oder 3,
   in welchem zumindest einige sequentielle Abtragsarbeitsgänge konzentrisch abgetragen werden und/oder in welchem zumindest einige sequentielle Abtragsarbeitsgänge nicht konzentrisch abgetragen werden.

5. Verfahren nach einem der vorhergehenden Ansprüche,
   in welchem die Ionenstrahlintensität und/oder die Einwirkdauer des Abtragens für individuelle Arbeitsgänge von mehreren Abtragsarbeitsgängen innerhalb des Abtragsschritts festgesetzt wird.

6. Verfahren nach einem der vorhergehenden Ansprüche,
   in welchem die abgetragene Tiefe mittels eines Rasterkraftmikroskops (26) gemessen wird.

7. Verfahren nach einem der vorstehenden Ansprüche,
   in welchem die Abtragtiefe während des Abtragsschritts gemessen wird.

8. Verfahren nach einem der vorstehenden Ansprüche,
   in welchem die Tiefe des abgetragenen Bereichs vor dem Abtragen eines folgenden Bereichs innerhalb des Abtragsschritts gemessen wird.

9. Verfahren zum Abtragen nach einem der vorstehenden Ansprüche,
   in welchem das Verfahren einen dreidimensionalen Gegenstand abträgt.

10. Verfahren zum Abtragen nach einem der vorstehenden Ansprüche, einschließend den Schritt des Bewirkens von zumindest einem Ätzarbeitsgang auf dem Gegenstand zum Erzeugen eines Feldes von Ätzgrübchen und Abtragen der Ätzgrübchen zum Erzeugen eines Feldes von dreidimensionalen Strukturen.

11. System (10) zum Abtragen eines dreidimensionalen Musters in einer Vorrichtung (20), einschließend:

    ein zum Erzeugen eines Ionenstrahls, der zum Abtragen eines Gegenstandes geeignet ist, betriebsbereiter Ionenstrahler;
    ein Diagnosesystem zum Festlegen oder Erhalten einer Abtragsgeschwindigkeit des Materials einer Vorrichtung auf der Grundlage der Stärke des Ionenstrahls und der Einwirkdauer des Ionenstrahls;
    eine Steuereinheit (22) zum Steuern des Ionenstrahlers (12) auf der Grundlage der festgelegten Abtragsgeschwindigkeit und des abzutragenden dreidimensionalen Musters;
wobei die Steuereinheit (22) zum Abtragen benachbarter Flächen der Vorrichtung (20) in unterschiedlichen Tiefen betriebsbereit ist, um ein dreidimensionales abgetragenes Muster zu erzeugen;
wobei das System **gekennzeichnet ist durch**:

eine Messvorrichtung (26) zum Messen des Istwerts der abgetragenen Tiefe durch den Ionenstrahler (12), wobei die Messvorrichtung (26) an die Steuereinheit (22) in einer Rückkopplungsform angeschlossen ist, und
wobei die Steuereinheit (22) zum Einstellen der Abtragsintensität und/oder der Abtragseinwirkdauer auf der Grundlage der gemessenen Abtragstiefe betriebsbereit ist.

12. System nach Anspruch 11,
in welchem die Steuereinheit (22) zum Steuern des Ionenstrahlers (12) zum Abtragen der Vorrichtung (20) in mehreren Abtragarbeitsgängen betriebsbereit ist.

13. System nach Anspruch 11 oder 12,
einschließend eine Datenbank aus Abtragstiefe, Strahlintensität und Strahleinwirkungszeit für eine oder mehrere Materialien,
wobei die Datenbank die Form einer Nachschlagetablelle hat.

14. System nach einem der Ansprüche 11 bis 13,
in welchem die Messvorrichtung (26) eine Rasterkraftmikroskopspitze (28) einschließt.

15. System nach einem der Ansprüche 11 bis 14,
einschließend ein Rasterelektonenmikroskop (14) und/oder einschließend eine Vakuumkammer (16) zum Halten einer abzutragenden Vorrichtung (20) und/oder einschließend wenigstens eine Ätzmaske (40) und eine Ätzstation zum Bewirken von zumindest einem Ätzarbeitsgang auf dem Gegenstand zum Erzeugen eines Feldes von Ätzgrübchen (48) vor dem Abtragen der Ätzgrübchen zum Erzeugen eines Feldes von dreidimensionalen Strukturen.

16. Vorrichtung mit einem dreidimensionalen Muster oder einer Struktur abgetragen durch ein System nach einem der vorstehenden Ansprüche 11 bis 15.

## Revendications

1. Procédé de fraisage d'une forme tridimensionnelle pour la production d'une structure tridimensionnelle dans un article (20), comprenant les étapes consistant à :

déterminer une vitesse de fraisage d'un matériau à fraiser en fonction de l'intensité et du temps de maintien d'un faisceau d'ions ; et
fraiser au moyen d'un fraisage par faisceau d'ions un article constitué dudit matériau en se basant sur la vitesse de fraisage déterminée, l'étape de fraisage fraisant des zones contiguës de l'article à différentes profondeurs pour générer une forme variant dans les trois dimensions ;
le procédé étant **caractérisé par** les étapes consistant à :

mesurer la profondeur réellement fraisée à l'intérieur de la structure fraisée ; et
régler l'intensité du fraisage et/ou le temps de maintien du fraisage en se basant sur la profondeur de fraisage mesurée.

2. Procédé de fraisage selon la revendication 1, dans lequel l'étape de fraisage comprend une pluralité de passes de fraisage, le procédé comprenant l'étape consistant à fraiser au moins une passe suivante de la pluralité de passes sur une région fraisée dans une passe précédente.

3. Procédé selon la revendication 2, dans lequel ladite passe de fraisage suivante fraise sur une partie d'une passe fraisée précédente.

4. Procédé de fraisage selon l'une quelconque des revendications 2 et 3, dans lequel au moins certaines passes de fraisage séquentielles sont fraisées de façon concentrique, et/ou dans lequel au moins certaines passes de fraisage séquentielles sont fraisées de façon non concentrique.

5. Procédé selon l'une quelconque des revendications précédentes, dans lequel l'intensité du faisceau d'ions et/ou le temps de maintien du fraisage sont réglés pour des passes individuelles d'une pluralité de passes de fraisage au sein de l'étape de fraisage.

6. Procédé selon l'une quelconque des revendications précédentes, dans lequel la profondeur fraisée est mesurée au moyen d'un microscope à force atomique (26).

7. Procédé selon l'une quelconque des revendications précédentes, dans lequel la profondeur de fraisage est mesurée pendant l'étape de fraisage.

8. Procédé selon l'une quelconque des revendications précédentes, dans lequel la profondeur d'une zone fraisée est mesurée avant le fraisage d'une zone suivante au sein de l'étape de fraisage.

9. Procédé de fraisage selon l'une quelconque des revendications précédentes, le procédé fraisant un article tridimensionnel.

10. Procédé de fraisage selon l'une quelconque des revendications précédentes, comprenant l'étape consistant à effectuer au moins une passe de gravure sur ledit article pour former un réseau de piqûres et fraiser lesdites piqûres pour former un réseau desdites structures tridimensionnelles.

11. Système (10) pour fraiser un motif tridimensionnel dans un dispositif (20), comprenant :

    une colonne d'ions (12) utilisable pour générer un faisceau d'ions capable de fraiser un objet ;
    un système de diagnostic destiné à déterminer ou obtenir une vitesse de fraisage du matériau du dispositif basée sur l'intensité du faisceau d'ions et le temps de maintien du faisceau d'ions ;
    une unité de commande (22) destinée à commander la colonne d'ions (12) en se basant sur la vitesse de fraisage déterminée et le motif tridimensionnel à fraiser ;
    l'unité de commande (22) étant utilisable pour fraiser des zones contiguës du dispositif (20) à différentes profondeurs de manière à former un motif fraisé tridimensionnel ;
    le système étant **caractérisé par** :

    un dispositif de mesure (26) destiné à mesurer la profondeur réellement fraisée par la colonne d'ions (12), le dispositif de mesure (26) étant couplé à l'unité de commande (22) d'une manière asservie et l'unité de commande (22) étant utilisable pour régler l'intensité du fraisage et/ou le temps de maintien du fraisage en se basant sur la profondeur de fraisage mesurée.

12. Système selon la revendication 11, dans lequel l'unité de commande (22) est utilisable pour commander la colonne d'ions (12) afin de fraiser le dispositif (20) dans une pluralité de passes de fraisage.

13. Système selon la revendication 11 ou 12, comportant une base de données de profondeur de fraisage, d'intensité de faisceau et de temps de maintien de faisceau pour un ou plusieurs matériaux, la base de données se présentant sous la forme d'une table de conversion.

14. Système selon l'une quelconque des revendications 11 à 13, dans lequel le dispositif de mesure (26) comporte une pointe de microscope à force atomique (28).

15. Système selon l'une quelconque des revendications 11 à 14, comportant une colonne de MEB (14), et/ou comportant une chambre à vide (16) pour maintenir un dispositif (20) à fraiser, et/ou comportant au moins un masque de gravure (40) et un poste de gravure pour effectuer au moins une passe de gravure sur ledit article afin de former un réseau de piqûres (48) avant de fraiser lesdites piqûres pour former un réseau desdites structures tridimensionnelles.

16. Dispositif ayant une structure ou un motif tridimensionnel fraisé par un système selon l'une quelconque des revendications 11 à 15.

Pitch

Spot size

Fig. 1

SEM column (optional)

14

10

12

Ion column

16

24

Patterning computer

Digital scan-coil control

Vacuum chamber

20

Pattern in CAD file

22

Specimen on instrument stage

Digital stage control

18

Fig. 2

Fig. 3

Fig. 4

Fig. 5

Fig. 6

Plan                                    Cross-section

First circle

## Fig. 7

Second circle

## Fig. 8

Ejected sample
atoms

Advancing ion beam
towards circle centre

Milled
volume

Re-deposited
material

Cross-section view of milled circle edge

Fig. 9

Advancing
ion beam

Ejected sample
atoms

Milled
volume

Cross-section view of milled circle edge

Fig. 10

Fig. 11

Fig. 12

**Fig. 13**

**Fig. 14a**

**Fig. 14b**

Fig. 15

Fig. 16

44

42

40

Fig. 17

Plasma etch

40

46

Fig. 18

Fig. 19

Fig. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• GB 2438241 A

### Non-patent literature cited in the description

• Focused ion beam milling: Depth control for three-dimensional microfabrication. **VASILE M J et al.** JOURNAL OF VACUUM SCIENCE & TECHNOLOGY B: MICROELECTRONICSPROCESSING AND PHENOMENA. AMERICAN VACUUM SOCIETY, 01 November 1997, vol. 15, 2350-2354

• Depth control of focused ion-beam milling from a numerical model of the sputter process. **VASILE MICHAEL J et al.** JOURNAL OF VACUUM SCIENCE & TECHNOLOGY B: MICROELECTRONICSPROCESSING AND PHENOMENA. AMERICAN VACUUM SOCIETY, 01 November 1999, vol. 17, 3085-3090

• Focused ion beam technology applied to microstructure fabrication. **VASILE MICHAEL J et al.** JOURNAL OF VACUUM SCIENCE & TECHNOLOGY B: MICROELECTRONICSPROCESSING AND PHENOMENA. AMERICAN VACUUM SOCIETY, 01 July 1998, vol. 16, 2499-2505